# FASCICULE DE BREVET EUROPEEN

(11) **EP 0 944 745 B1**
(45) Date de publication et mention de la délivrance du brevet: **11.06.2003**
(21) Numéro de dépôt: 97949843.3
(22) Date de dépôt: 09.12.1997
(51) Int. Cl.: C23C 14/56, C23C 14/34

(54) **PROCEDE ET DISPOSITIF POUR LA FORMATION D'UN REVETEMENT SUR UN SUBSTRAT, PAR PULVERISATION CATHODIQUE**
VERFAHREN UND VORRICHTUNG ZUR HERSTELLUNG EINER BESCHICHTUNG AUF EINEM SUBSTRATMITTELS KATHODENZERSTÄUBUNG
PROCESS AND DEVICE FOR FORMING A COATING ON A SUBSTRATE BY CATHODE SPUTTERING

(30) Priorité: 10.12.1996 BE 9601030
(43) Date de publication de la demande: 29.09.1999
(73) Titulaire: Recherche et Developpement du Groupe Cockerill Sambre, 4000 Liege (BE)
(72) Inventeur: VANDEN BRANDE, Pierre, B-1040 Bruxelles (BE); WEYMEERSCH, Alain, B-1300 Wavre (BE)
(74) Mandataire: Claeys, Pierre
(86) Numéro de dépôt international: BE9700133
(87) Numéro de publication internationale: WO98026108

(56) Documents cités:
- EP-A- 0 685 571
- DE-A- 3 400 843
- PATENT ABSTRACTS OF JAPAN vol. 018, no. 448 (C-1240), 22 août 1994 & JP 06 136537 A (ISHIKAWAJIMA HARIMA HEAVY IND CO LTD), 17 mai 1994,
- PATENT ABSTRACTS OF JAPAN vol. 008, no. 178 (C-238), 16 août 1984 & JP 59 074277 A (MITSUBISHI JUKOGYO KK), 26 avril 1984,
- PATENT ABSTRACTS OF JAPAN vol. 017, no. 247 (C-1059), 18 mai 1993 & JP 04 371577 A (SONY CORP), 24 décembre 1992,

## Description

La présente invention concerne un procédé pour la formation d'un revêtement sur un substrat, par pulvérisation cathodique, comprenant
- un transfert du substrat entre une entrée et une sortie d'une enceinte de pulvérisation cathodique,
- un passage d'au moins une surface à revêtir du substrat parallèlement à une superficie d'une cible, orientée vers cette surface et contenant un ou des éléments à déposer sur le substrat, et
- au cours de ce passage, une pulvérisation cathodique du ou des éléments à déposer susdits sur la totalité de la surface à revêtir, à partir de ladite surperficie de la cible.

On connaît depuis longtemps déjà de tels procédés et dispositifs de pulvérisation cathodique (voir par exemple EP-A-0685571).

Un problème rencontré par les dispositifs actuellement connus est que les substrats à revêtir, par exemple en forme de bandes, présentent des largeurs variables. Cela signifie que si, devant une cible de longueur donnée d'une enceinte de pulvérisation cathodique, on fait défiler un substrat de largeur inférieure à la cible, il se produit des pertes de matière qui sont pulvérisées en dehors du substrat et qui contaminent l'enceinte.

Pour éviter ces problèmes, on prévoit actuellement l'utilisation de cibles de longueurs variables que l'on échange en fonction de la largeur du substrat à traiter. Cela nécessite beaucoup de place, des temps de montage et de démontage, ainsi qu'un stockage de cibles différentes.

Suivant une autre solution, on fait usage d'une cible unique et d'éléments de masquage qui peuvent couvrir au moins une des extrémités de la cible, si le substrat à traiter présente une largeur inférieure à la longueur de la cible. Ces masques doivent toutefois être remplacés ou nettoyés régulièrement et ils ne fournissent pas une solution réelle à la perte de matière pulvérisée.

La présente invention a pour but de mettre au point un procédé et un dispositif relativement simples et peu coûteux, qui permettent de surmonter les problèmes mentionnés ci-dessus.

Pour cela, l'invention prévoit un procédé tel qu'indiqué au début, comprenant
- un revêtement de surfaces de substrats transférés dans l'enceinte, qui présentent une largeur variable, avec une largeur maximale prédéterminée, à l'aide d'une cible dont la superficie susdite est d'une longueur invariable correspondant approximativement à ladite largeur maximale du substrat, et,
- en fonction de la largeur du substrat en cours de revêtement, un déplacement relatif entre la superficie de la cible et la surface à revêtir du substrat de façon que sensiblement la totalité de la superficie de la cible se trouve constamment en face de la surface à revêtir, pendant la pulvérisation cathodique.

On obtient ainsi un rendement maximal d'une cible, unique pour tous les substrats, qui est toujours située dans sa totalité en face de la surface à revêtir du substrat, tout en permettant une pulvérisation cathodique sur la totalité de la surface à revêtir, pendant le passage du substrat dans l'enceinte de pulvérisation.

Suivant un mode de réalisation de l'invention, les substrats sont des bandes de matière qui défilent suivant une direction linéaire devant la cible et, en fonction de la largeur de la bande, le procédé comprend un déplacement de la cible entre une position longitudinale perpendiculaire à la direction de déplacement de la bande, lorsque la largeur de bande est maximale, et une position longitudinale en oblique par rapport à cette direction de défilement, lorsque la largeur de bande est inférieure à la largeur maximale. Par un déplacement simple et demandant peu d'espace, la cible peut ainsi être rapidement adaptée pour des bandes de largeurs variables à traiter successivement dans l'enceinte de pulvérisation.

Suivant un mode de réalisation avantageux de l'invention, ce déplacement relatif comprend un pivotement de la cible dans l'enceinte. Ce pivotement peut de préférence avoir lieu autour d'un axe central de la cible ou d'un axe excentré, par exemple disposé à une de ses extrémités. On peut aussi prévoir un mouvement de translation de la cible, simultanément ou ultérieurement au mouvement de pivotement.

Il est évident que le procédé est applicable à n'importe quel substrat dont une surface peut être revêtue par une pulvérisation cathodique. On peut donc l'utiliser par exemple pour revêtir des bandes ou plaques de métal, de verre, de papier, de matières plastiques, entre autres. Néanmoins son application n'est pas limitée aux produits bidimensionnels comme des bandes, mais elle peut être prévue aussi pour le revêtement de surfaces d'objets tridimensionnels, par exemple des barres, des rails, etc....

Le procédé de pulvérisation n'est pas limité à une pulvérisation cathodique classique avec cible solide. On peut aussi prévoir des cibles à couche superficielle liquide (voir par exemple EP-A-0685571). On peut aussi envisager simultanément une évaporation par pulvérisation de la couche liquide d'une telle cible, avec condensation ultérieure sur la surface à revêtir.

Des modes de réalisation particuliers du procédé suivant l'invention sont indiqués aux revendications 1 à 9.

L'invention prévoit également un dispositif pour la formation d'un revêtement sur un substrat, par pulvérisation cathodique, comprenant
- une enceinte de pulvérisation cathodique pourvue d'une entrée et d'une sortie pour le substrat,
- des moyens de transfert pour déplacer le substrat entre l'entrée et la sortie,
- une cible présentant une superficie orientée vers une surface à revêtir du substrat et disposée parallèlement à celle-ci et contenant un ou des éléments à déposer sur le substrat, et
- des moyens pour réaliser la pulvérisation cathodique du ou des éléments susdits à déposer à partir de la superficie susdite de la cible vers le substrat, ce dispositif étant prévu pour le revêtement de surfaces de substrats de largeur variable, avec une largeur maximale prédéterminée, et comprenant une cible dont la superficie est de longueur invariable correspondant approximativement à la largeur maximale du substrat ainsi que des moyens de déplacement relatif entre la superficie de la cible et la surface à revêtir du substrat de façon que sensiblement la totalité de la superficie de la cible se trouve constamment en face de la surface à revêtir, pendant la pulvérisation cathodique.

Des formes de réalisation particulières du dispositif suivant l'invention sont indiquées aux revendications 10 à 14.

D'autres détails et particularités de l'invention ressortiront de la description donnée ci-après, à titre non limitatif et avec référence aux dessins annexés.

La figure 1 représente une vue en coupe schématique d'une enceinte de pulvérisation cathodique suivant l'invention, suivant la ligne I-I de la figure 2.

La figure 2 représente une vue en coupe schématique de cette enceinte de pulvérisation cathodique, suivant la ligne II-II de la figure 1.

La figure 3 représente une vue analogue à la figure 2 d'une variante de réalisation suivant l'invention.

La figure 4 représente une vue analogue à la figure 2 d'encore une autre variante de réalisation suivant l'invention.

Dans les différents dessins, les références identiques ou analogues sont désignées par les mêmes références.

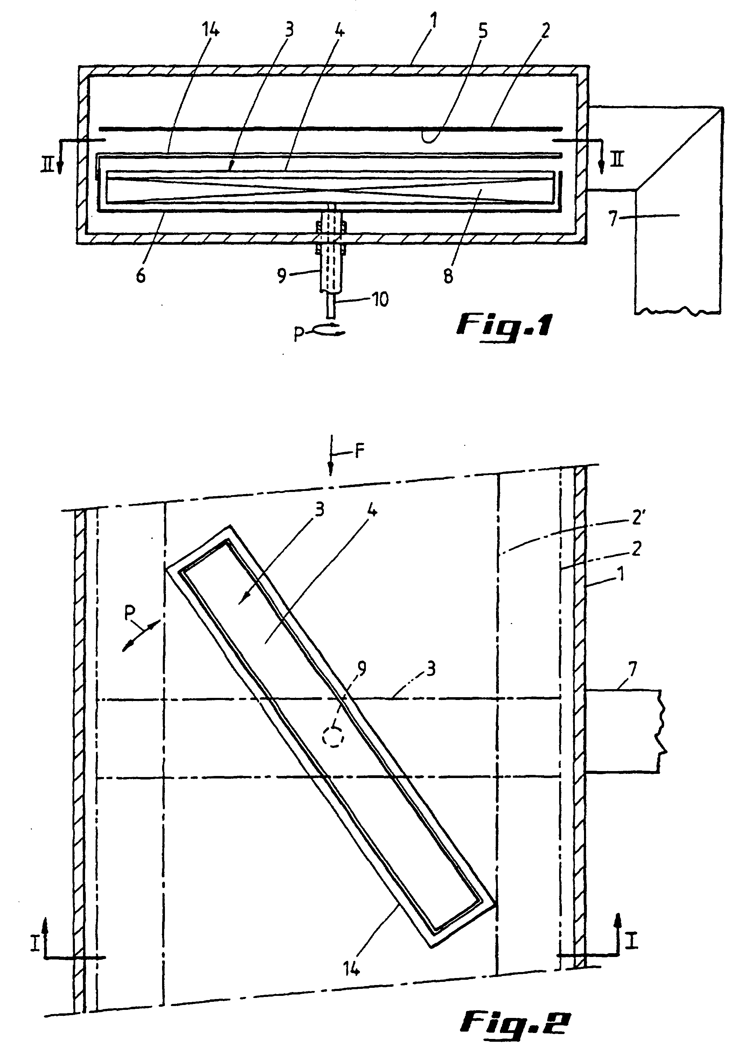

Sur les figures 1 et 2, on peut observer un dispositif suivant l'invention pour la formation d'un revêtement sur un substrat, par pulvérisation cathodique. Ce dispositif comprend une enceinte de pulvérisation cathodique 1 qui est pourvue d'une entrée et d'une sortie non représentées pour le substrat 2. Dans l'exemple de réalisation, ce substrat 2 est une bande de matière qui présente une largeur maximale au-delà de laquelle le présent dispositif ne pourrait plus convenir pour appliquer un revêtement.

A l'intérieur de l'enceinte est disposée une cible, désignée d'une manière générale par la référence 3. Cette cible présente une superficie 4, orientée vers une surface à revêtir 5 du substrat 2 et disposée parallèlement à celle-ci. La cible 3 contient un ou des éléments à déposer sur le substrat par pulvérisation cathodique, ce ou ces éléments pouvant être par exemple des métaux.

Le dispositif comprend également, d'une manière connue en soi, des moyens de transfert non représentés et destinés au déplacement du substrat entre l'entrée et la sortie de l'enceinte. Dans le cas d'un substrat 2 en forme de bande, on peut prévoir que celle-ci soit enroulée sur une bobine d'alimentation à l'extérieur de l'enceinte, passée dans l'enceinte, puis réenroulée sur une bobine de stockage prévue également à l'extérieur de l'enceinte. Cette dernière bobine pourrait par exemple être entraînée en rotation par un moteur électrique.

Enfin, l'enceinte 1 comporte également des moyens connus pour réaliser une pulvérisation cathodique d'au moins un élément à déposer à partir de la superficie susdite de la cible vers le substrat. L'enceinte renferme à cet effet une douche à gaz 14, en forme de conduit perforé formant un cadre au-dessus de la cible. C'est à partir de ce conduit qu'est introduit un gaz inerte à ioniser, tel que de l'argon, ou éventuellement un mélange gazeux à base d'argon dans lequel se trouve également un gaz réactif, tel que C₂ H₂, O₂, etc.... Cette douche à gaz 14 est, dans l'exemple de réalisation illustré, supportée de manière fixe par un écran de blindage 6 entourant partiellement la cible 3.

Comme moyens pour réaliser une pulvérisation cathodique, l'enceinte comporte en outre un conduit à vide 7, relié à une pompe à vide non représentée, pour réaliser une dépression à l'intérieur de l'enceinte, et un circuit magnétique 8 connu en soi d'un magnétron conventionnel. Celui-ci est solidaire de la cible 3 et permet la réalisation d'un plasma à proximité de la superficie 4 de la cible 3. Dans ce bloc formé par la cible 3 et le circuit magnétique, on peut en outre prévoir d'une manière connue en soi, des systèmes de chauffage et/ou de refroidissement pour réguler la température, ainsi que des conducteurs d'électricité connectés à la cible.

Dans l'exemple de réalisation suivant l'invention, illustré sur les figures 1 et 2, le dispositif est prévu pour le revêtement de surfaces de substrats de largeur variable. En plus du substrat 2 à largeur maximale, on a aussi représenté sur la figure 2 un substrat 2', dont la largeur est nettement inférieure.

Pour traiter ces deux substrats, il est prévu, dans le dispositif suivant l'invention, d'utiliser la même cible 3, dont la longueur correspond approximativement à la largeur maximale du substrat 2 (voir figure 2), dans la position de la cible perpendiculairement à la direction de défilement F du substrat.

Pour traiter le substrat 2', le dispositif comprend des moyens permettant d'effectuer un déplacement relatif entre la superficie 4 de la cible 3 et la surface à revêtir 5 du substrat 2.

Dans l'exemple de réalisation illustré sur les figures 1 et 2, dans la position représentée en traits pleins de la cible 3 sur la figure 2, celle-ci présente une position longitudinale en oblique par rapport à la direction F de défilement du substrat. Dans cette position, la totalité de la superficie 4 est en face du substrat 2 et la totalité de la surface à revêtir 5 du substrat passe devant la cible 3 pendant la pulvérisation cathodique, ce qui réduit à un minimum des pertes de matière.

Comme moyens de déplacement relatif précédemment cités, il est prévu dans l'exemple de réalisation illustré sur les figures 1 et 2, un axe de pivotement creux 9 qui traverse la paroi de l'enceinte 1 d'une manière étanche et qui supporte de manière fixe l'écran de blindage 6, de manière à permettre une rotation de cet écran conjointement à cet axe. L'axe 9 est entraîné en rotation par un mécanisme courant situé à l'extérieur de l'enceinte et non représenté. A l'intérieur de cet axe de pivotement creux, passe un tube creux 10 qui supporte, en leur centre, la cible 3 et le circuit magnétique 8 et qui est solidaire en rotation de l'axe de pivotement 9. Dans ce tube 10 peuvent par exemple être introduites les alimentations en courant, gaz, agents de chauffage et/ou de refroidissement, entre autres. Cet agencement permet donc une rotation solidaire de l'écran 6, de la douche à gaz 5, de la cible 3 et du magnétron 8 ainsi que de l'axe 9 suivant la flèche P, alors que l'enceinte 1 reste stationnaire.

Dans l'exemple de réalisation suivant la figure 3, les moyens de déplacement relatif entre la superficie 4 de la cible 3 et la surface à revêtir 5 du substrat 2 comprennent une glissière 11 sur laquelle la cible 3 et le circuit magnétique 8 sont supportés de manière à pouvoir coulisser suivant la double flèche T. Cette glissière est supportée dans l'enceinte sur un axe de rotation 12 disposé latéralement au parcours des substrats à revêtir et permettant un pivotement de la cible suivant la double flèche P.

Le coulissement de la cible 3 sur la glissière 11 peut être obtenu par n'importe quel moyen approprié, par exemple à l'aide d'un vérin hydraulique non représenté. La rotation de l'axe 12 est obtenue comme celle de l'axe 9, par des moyens extérieurs à l'enceinte.

Comme il y a successivement ou conjointement à la rotation de la cible, une translation de celle-ci, on peut prévoir, dans ce cas, des flexibles non présentés qui sont raccordés à la cible pour permettre son alimentation en agents de refroidissement et/ou de chauffage, en électricité, etc...

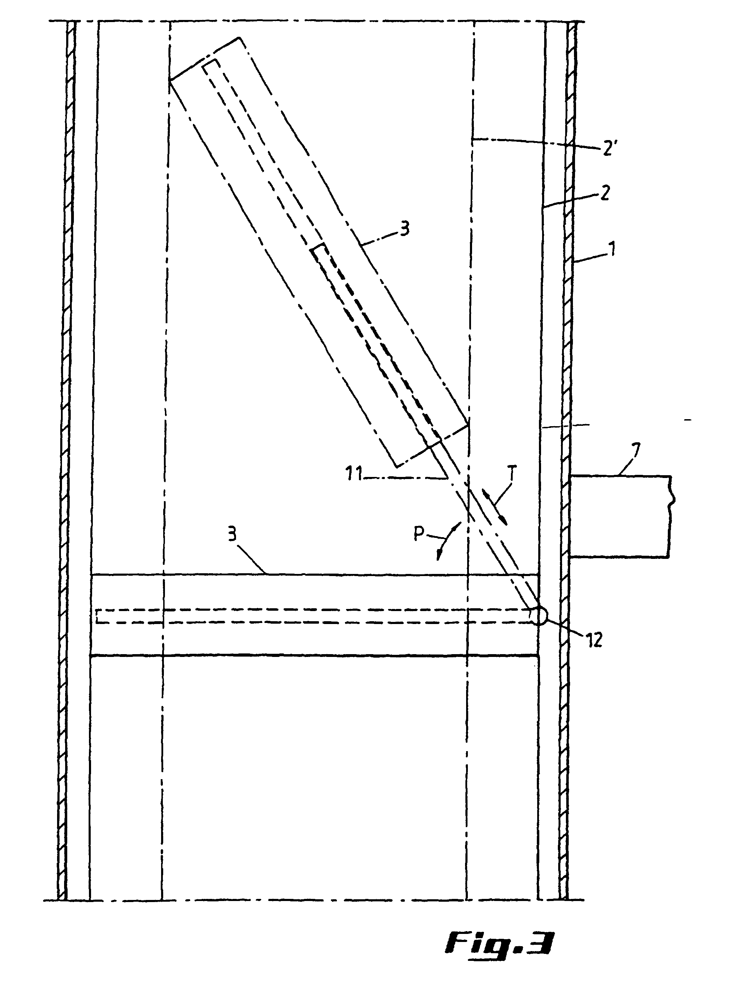

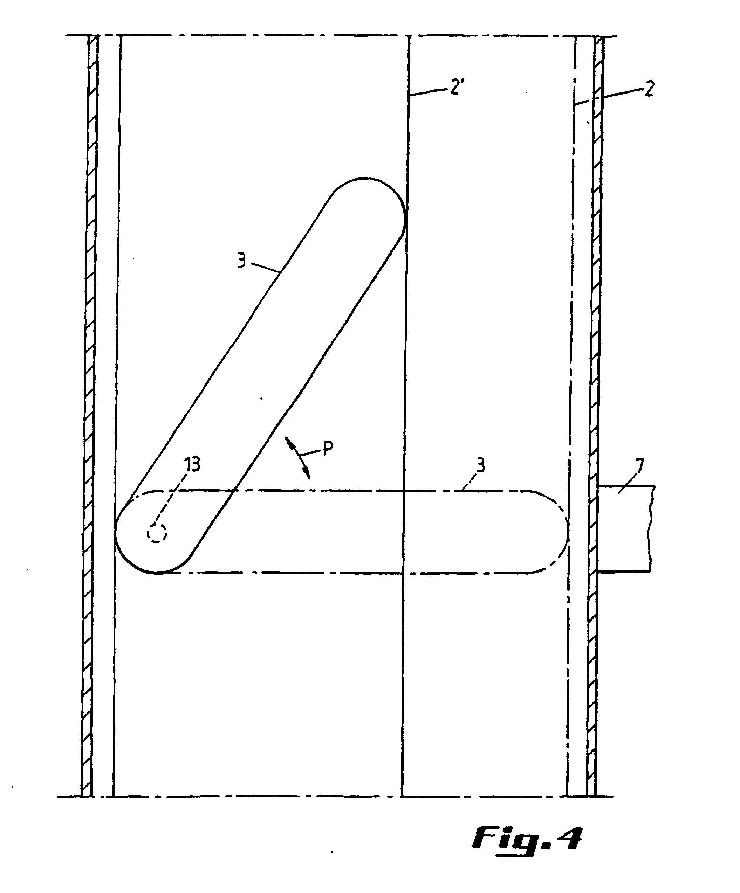

Ainsi qu'il ressort de la figure 4, la cible présente dans ce cas des extrémités semi-circulaires et elle est suportée à l'une de ses extrémités par un axe de rotation 12. La cible pivote suivant la double flèche P autour de l'axe excentré 12 lorsque le substrat 2' plus étroit est à revêtir. Dans ce dernier cas, le substrat ne défile plus centralement dans l'enceinte, comme dans les exemples de réalisation précédemment décrits, mais de manière décalée vers un des côtés de l'enceinte, adjacent à l'axe 12. Par cette configuration de cible, celle-ci peut être toujours maintenue tangente aux bords du substrat, ce qui favorise encore davantage l'absence de perte de matière.

Il doit être entendu que la présente invention n'est en aucune façon limitée aux formes de réalisation décrites ci-dessus et que bien des modifications peuvent y être apportées sans sortir du cadre des revendications qui suivent.

Par exemple, si les cibles sont de préférence en position horizontale, et si leur superficie à partir de laquelle s'effectue une pulvérisation cathodique est de préférence dirigée vers le haut, il est possible de prévoir des cibles disposées verticalement ou en oblique. Il est nécessaire d'orienter alors parallèlement le substrat à revêtir.

Une orientation différente n'est toutefois pas possible pour les cibles présentant une superficie liquide et où on peut prévoir, en plus d'une pulvérisation cathodique, une évaporation du liquide et sa condensation ultérieure sur le substrat.

Le système d'entraînement des cibles en rotation et/ou en translation peut être interne à l'enceinte ou externe à celle-ci.

## Revendications

1. Procédé pour la formation d'un revêtement sur un substrat, par pulvérisation cathodique, comprenant
- un transfert du substrat entre une entrée et une sortie d'une enceinte de pulvérisation cathodique,
- un passage d'au moins une surface à revêtir du substrat parallèlement à une superficie d'une cible, orientée vers cette surface et contenant un ou des éléments à déposer sur le substrat, et
- au cours de ce passage, une pulvérisation cathodique du ou des éléments à déposer susdits sur la totalité de la surface à revêtir, à partir de ladite surperficie de la cible,
**caractérisé en ce qu'**il comprend
- un revêtement de surfaces de substrats transférés dans l'enceinte, qui présentent une largeur variable, avec une largeur maximale prédéterminée, à l'aide d'une cible dont la superficie susdite est d'une longueur invariable correspondant approximativement à ladite largeur maximale du substrat, et,
- en fonction de la largeur du substrat en cours de revêtement, un déplacement relatif entre la superficie de la cible et la surface à revêtir du substrat de façon que sensiblement la totalité de la superficie de la cible se trouve constamment en face de la surface à revêtir, pendant la pulvérisation cathodique.

2. Procédé suivant la revendication 1, **caractérisé en ce que** les substrats à revêtir sont des bandes de matière qui défilent suivant une direction linéaire devant la cible et **en ce que**, en fonction de la largeur de la bande, le procédé comprend un déplacement de la cible entre une position longitudinale perpendiculaire à la direction de défilement de la bande, lorsque la largeur de bande est maximale, et une position longitudinale en oblique par rapport à cette direction de défilement, lorsque la largeur de bande est inférieure à la largeur maximale.

3. Procédé suivant l'une ou l'autre des revendications 1 et 2, **caractérisé en ce que** le déplacement relatif entre la superficie de la cible et la surface à revêtir du substrat comprend un pivotement de la cible dans l'enceinte au cours duquel ladite superficie reste parallèle à ladite surface à revêtir, et à distance inchangée de celle-ci.

4. Procédé suivant la revendication 3, **caractérisé en ce qu'**il comprend ledit pivotement autour d'un axe central de la cible.

5. Procédé suivant la revendication 3, **caractérisé en ce qu'**il comprend ledit pivotement autour d'un axe excentré de la cible, en particulier autour d'une des extrémités longitudinales de celle-ci.

6. Procédé suivant la revendication 5, **caractérisé en ce qu'**il comprend un mouvement de translation de la cible, simultanément ou ultérieurement au mouvement de pivotement.

7. Procédé suivant l'une quelconque des revendications 1 à 6, **caractérisé en ce que** les substrats de matière à revêtir sont constitués de métal, de verre, de papier, de matières plastiques ou de matières analogues.

8. Procédé suivant l'une quelconque des revendications 1 à 7, **caractérisé en ce que** la superficie susdite de la cible est formée d'une couche superficielle solide ou liquide.

9. Procédé suivant l'une quelconque des revendications 1 à 7, **caractérisé en ce que** la superficie susdite de la cible est liquide et **en ce qu'**il comprend, simultanément à ladite pulvérisation cathodique, une évaporation du ou des éléments servant au revêtement, suivie de leur condensation sur le substrat à revêtir.

10. Dispositif pour la formation d'un revêtement sur un substrat (2), par pulvérisation cathodique, comprenant
- une enceinte de pulvérisation cathodique (1) pourvue d'une entrée et d'une sortie pour le substrat,
- des moyens de transfert pour déplacer le substrat (2) entre l'entrée et la sortie,
- une cible (3) présentant une superficie (4) orientée vers une surface (5) à revêtir du substrat (2) et disposée parallèlement à celle-ci et contenant un ou des éléments à déposer sur le substrat et
- des moyens (3, 7, 8, 14) pour réaliser la pulvérisation cathodique du ou des éléments à déposer susdits à partir de la superficie (4) susdite de la cible vers le substrat,
**caractérisé en ce que** le dispositif est prévu pour le revêtement de surfaces de substrats de largeur variable, avec une largeur maximale prédéterminée, et **en ce qu'**il comprend une cible (3) dont la superficie (4) est de longueur invariable correspondant approximativement à la largeur maximale du substrat (2) ainsi que des moyens (9-13) de déplacement relatif entre la superficie (4) de la cible (3) et la surface à revêtir (5) du substrat (1) de façon que sensiblement la totalité de la superficie de la cible se trouve constamment en face de la surface à revêtir, pendant la pulvérisation cathodique.

11. Dispositif suivant la revendication 10, **caractérisé en ce que** les moyens de déplacement relatif comprennent un axe de pivotement (9) qui supporte la cible (3) en son centre de manière à permettre une rotation de celle-ci autour de ce dernier, parallèlement à la surface à revêtir (5).

12. Dispositif suivant la revendication 11, **caractérisé en ce que** l'axe (9) est creux et traverse l'enceinte (1) de manière étanche en permettant l'introduction dans l'enceinte de conduits utilitaires, notament pour l'alimentation en eau, en gaz et/ou en électricité.

13. Dispositif suivant la revendication 10, **caractérisé en ce que** les moyens de déplacement relatif comprennent une glissière (11) sur laquelle la cible (3) peut coulisser suivant un mouvement de translation, et un axe de rotation (12) sur lequel la glissière (11) est supportée de manière à pouvoir pivoter parallèlement à la surface à revêtir (5).

14. Dispositif suivant la revendication 10, **caractérisé en ce que** les moyens de déplacement relatif comprennent un axe de pivotement (13) qui supporte la cible (3) de manière excentrée de façon à permettre une rotation de celle-ci parallèlement à la surface à revêtir (5).

## Patentansprüche

1. Verfahren zur Bildung einer Beschichtung auf einem Substrat, durch Kathodenzerstäubung, umfassend
- einen Transfer des Substrats zwischen einem Eingang und einem Ausgang eines Kathodenzerstäubungsraums,
- ein Vorbeibewegen mindestens einer zu beschichtenden Oberfläche des Substrats parallel zu einer Fläche eines Targets, die gegen diese Oberfläche gerichtet ist und ein Element oder Elemente, die auf dem Substrat abzulagern sind, enthält, und
- während dieses Vorbeibewegens, eine Kathodenzerstäubung des oder der vorstehend genannten abzulagernden Elemente(s) auf der gesamten zu beschichtenden Oberfläche, ausgehend von der Fläche des Targets,
**dadurch gekennzeichnet, daß** es umfaßt
- eine Beschichtung von Oberflächen von in dem Raum transferierten Substraten, die eine variable Breite aufweisen, mit einer vorherbestimmten maximalen Breite, mittels eines Targets, dessen vorstehend genannte Fläche von einer unveränderlichen Länge ist, welche annähernd der maximalen Breite des Substrats entspricht, und,
- in Abhängigkeit von der Breite des in Beschichtung befindlichen Substrats, eine Relativbewegung zwischen der Fläche des Targets und der zu beschichtenden Oberfläche des Substrats in der Weise, daß im wesentlichen die gesamte Fläche des Targets sich ständig gegenüber der zu beschichtenden Oberfläche befindet, während der Kathodenzerstäubung.

2. Verfahren nach Anspruch 1, **dadurch gekennzeichnet, daß** die zu beschichtenden Substrate Materialbänder sind, die sich längs einer linearen Richtung an dem Target vorbeibewegen, und dadurch, daß, in Abhängigkeit von der Breite des Bandes, das Verfahren eine Bewegung des Targets zwischen einer zu der Bewegungsrichtung des Bandes senkrechten Longitudinalposition, wenn die Breite des Bandes maximal ist, und einer in Bezug auf diese Bewegungsrichtung schrägen Longitudinalposition, wenn die Breite des Bandes kleiner ist als die maximale Breite, umfaßt.

3. Verfahren nach einem der Ansprüche 1 oder 2, **dadurch gekennzeichnet, daß** die Relativbewegung zwischen der Fläche des Targets und der zu beschichtenden Oberfläche des Substrats ein Schwenken des Targets in dem Raum umfaßt, während dessen die Fläche parallel zu der zu beschichtenden Oberfläche und in unveränderter Distanz von derselben bleibt.

4. Verfahren nach Anspruch 3, **dadurch gekennzeichnet, daß** es das Schwenken um eine zentrale Achse des Targets umfaßt.

5. Verfahren nach Anspruch 3, **dadurch gekennzeichnet, daß** es das Schwenken um eine exzentrisch angeordnete Achse des Targets, insbesondere um eines der longitudinalen Enden desselben, umfaßt.

6. Verfahren nach Anspruch 5, **dadurch gekennzeichnet, daß** es eine Translationsbewegung des Targets, gleichzeitig mit oder nach der Schwenkbewegung, umfaßt.

7. Verfahren nach einem der Ansprüche 1 bis 6, **dadurch gekennzeichnet, daß** die zu beschichtenden Materialsubstrate aus Metall, Glas, Papier, Kunststoffmaterialien oder ähnlichen Materialien gebildet sind.

8. Verfahren nach einem der Ansprüche 1 bis 7, **dadurch gekennzeichnet, daß** die vorstehend genannte Fläche des Targets aus einer festen oder flüssigen Oberflächenschicht gebildet ist.

9. Verfahren nach einem der Ansprüche 1 bis 7, **dadurch gekennzeichnet, daß** die vorstehend genannte Fläche des Targets flüssig ist und dadurch, daß es, gleichzeitig mit der Kathodenzerstäubung, eine Verdampfung des oder der zur Beschichtung dienenden Elemente(s), gefolgt von deren Kondensation auf dem zu beschichtenden Substrat, umfaßt.

10. Vorrichtung zur Bildung einer Beschichtung auf einem Substrat (2), durch Kathodenzerstäubung, umfassend
- einen Kathodenzerstäubungsraum (1), der mit einem Eingang und einem Ausgang für das Substrat versehen ist,
- Transfermittel zum Bewegen des Substrats (2) zwischen dem Eingang und dem Ausgang,
- ein Target (3), das eine Fläche (4) aufweist, welche gegen eine zu beschichtende Oberfläche (5) des Substrats (2) gerichtet ist und parallel zu derselben angeordnet ist und ein Element oder Elemente, die auf dem Substrat abzulagern sind, enthält, und
- Mittel (3, 7, 8, 14) zum Durchführen der Kathodenzerstäubung des oder der vorstehend genannten abzulagernden Elemente(s), ausgehend von der vorstehend genannten Fläche (4) des Targets gegen das Substrat,
**dadurch gekennzeichnet, daß** die Vorrichtung für die Beschichtung von Oberflächen von Substraten von variabler Breite, mit einer vorherbestimmten maximalen Breite, vorgesehen ist, und dadurch, daß sie ein Target (3) umfaßt, dessen Fläche (4) von einer unveränderlichen Länge ist, welche annähernd der maximalen Breite des Substrats (2) entspricht, sowie Mittel (9-13) für eine Relativbewegung zwischen der Fläche (4) des Targets (3) und der zu beschichtenden Oberfläche (5) des Substrats (1) in der Weise, daß im wesentlichen die gesamte Fläche des Targets sich ständig gegenüber der zu beschichtenden Oberfläche befindet, während der Kathodenzerstäubung.

11. Vorrichtung nach Anspruch 10, **dadurch gekennzeichnet, daß** die Mittel für die Relativbewegung eine Schwenkachse (9) umfassen, die das Target (3) in seiner Mitte in der Weise trägt, daß eine Drehung desselben um diese letztere möglich ist, parallel zu der zu beschichtenden Oberfläche (5).

12. Vorrichtung nach Anspruch 11, **dadurch gekennzeichnet, daß** die Achse (9) hohl ist und den Raum (1) in abgedichteter Weise durchquert, wodurch die Einführung von Nutzleitungen, insbesondere für die Versorgung mit Wasser, Gas und/oder Elektrizität, in den Raum ermöglicht wird.

13. Vorrichtung nach Anspruch 10, **dadurch gekennzeichnet, daß** die Mittel für die Relativbewegung eine Schiene (11) umfassen, an welcher das Target (3) sich gemäß einer Translationsbewegung verschieben kann, und eine Drehachse (12), an welcher die Schiene (11) in der Weise getragen ist, daß sie parallel zu der zu beschichtenden Oberfläche (5) schwenken kann.

14. Vorrichtung nach Anspruch 10, **dadurch gekennzeichnet, daß** die Mittel für die Relativbewegung eine Schwenkachse (13) umfassen, die das Target (3) in exzentrisch angeordneter Weise trägt, derart, daß eine Drehung desselben parallel zu der zu beschichtenden Oberfläche (5) möglich ist.

## Claims

1. Process for forming a coating on a substrate by cathodic sputtering comprising
- transfer of the substrate between an inlet and an outlet of a cathodic sputtering chamber,
- passage of at least one surface to be coated of the substrate parallel to a surface of a target, oriented towards this substrate surface and containing one or more elements to be deposited on the substrate, and
- during this passage, cathodic sputtering of said one or more elements to be deposited on the entirety of the surface to be coated from said target surface,
**characterised in that** it comprises
- surface coating of substrates transferred into the chamber, which substrates are of variable width with a predetermined maximum width, by means of a target, said surface of which is of an invariable length approximately matching said maximum width of the substrate, and,
- depending upon the width of the substrate being coated, relative displacement between the surface of the target and the surface to be coated of the substrate, such that substantially the entirety of the surface of the target is constantly located opposite the surface to be coated during cathodic sputtering.

2. Process according to claim 1, **characterised in that** the substrates to be coated are strips of material which proceed in a linear direction before the target and **in that**, depending upon the width of the strip, the process comprises displacement of the target between a longitudinal direction perpendicular to the direction of motion of the strip, when the width of the strip is at its maximum, and an oblique longitudinal position relative to this direction of motion, when the width of the strip is less than the maximum width.

3. Process according to one or the other of claims 1 and 2, **characterised in that** the relative displacement between the surface of the target and the surface to be coated of the substrate comprises pivoting of the target in the chamber, during which pivoting said target surface remains parallel to said surface to be coated, and at an unchanged distance therefrom.

4. Process according to claim 3, **characterised in that** it comprises said pivoting around a central shaft of the target.

5. Process according to claim 3, **characterised in that** it comprises said pivoting around an eccentric shaft of the target, in particular around one of the longitudinal ends thereof.

6. Process according to claim 5, **characterised in that** it comprises a translational movement of the target, simultaneously with or subsequent to the pivoting movement.

7. Process according to any of claims 1 to 6, **characterised in that** the material substrates to be coated are composed of metal, glass, paper, plastics or similar materials.

8. Process according to any of claims 1 to 7, **characterised in that** said surface of the target is formed by a solid or liquid surface layer.

9. Process according to any of claims 1 to 7, **characterised in that** said surface of the target is liquid and **in that** it comprises, simultaneously with said cathodic sputtering, evaporation of the one or more elements providing the coating, followed by condensation thereof on the substrate to be coated.

10. Device for forming a coating on a substrate (2) by cathodic sputtering comprising
- a cathodic sputtering chamber (1) provided with an inlet and outlet for the substrate,
- transfer means to convey the substrate (2) between the inlet and outlet,
- a target (3) having a surface (4) oriented towards a surface (5) to be coated of the substrate (2) and arranged parallel thereto and containing one or more elements to be deposited on the substrate, and
- means (3, 7, 8, 14) to achieve cathodic sputtering of said one or more elements to be deposited from said surface (4) of the target onto the substrate,
**characterised in that** the device is provided for coating substrate surfaces of variable width with a predetermined maximum width, and **in that** it comprises a target (3), the surface (4) of which is of an invariable length approximately matching the maximum width of the substrate (2), as well as means (9-13) to provide relative displacement between the surface (4) of the target (3) and the surface to be coated (5) of the substrate (1) such that substantially the entirety of the surface of the target is constantly located opposite the surface to be coated during cathodic sputtering.

11. Device according to claim 10, **characterised in that** the relative displacement means comprise a pivot shaft (9) which supports the target (3) in the centre thereof in such a manner as to allow the rotation thereof around the shaft, parallel to the surface to be coated (5).

12. Device according to claim 11, **characterised in that** the shaft (9) is hollow and passes through the chamber (1) in an airtight manner, allowing utility lines to be introduced into the chamber, in particular for supplying water, gas and/or electricity.

13. Device according to claim 10, **characterised in that** the relative displacement means comprise a slider (11), on which the target (3) may slide in accordance with a translational movement, and a rotation shaft (12) on which the slider (11) is supported in such a manner that it may pivot parallel to the surface to be coated (5).

14. Device according to claim 10, **characterised in that** the relative displacement means comprise a pivot shaft (13) which supports the target (3) eccentrically in such a manner as to allow rotation thereof parallel to the surface to be coated (5).
